# EUROPEAN PATENT SPECIFICATION

(11) **EP 0 911 960 B1**
(45) Date of publication and mention of the grant of the patent: **04.09.2002**
(21) Application number: 98308399.9
(22) Date of filing: 14.10.1998
(51) Int. Cl.: H03B 5/12, H03H 5/12, H03J 5/24

(54) **Resonance circuit for balanced oscillator**
Resonanzschaltung für Gegentaktoszillator
Circuit résonateur pour oscillateur équilibré

(30) Priority: 21.10.1997 JP 28825497
(43) Date of publication of application: 28.04.1999
(73) Proprietor: ALPS ELECTRIC CO., LTD., Ota-ku Tokyo 145 (JP)
(72) Inventor: Yamagata, Yuichiro, Soma-shi, Fukushima-ken (JP)
(74) Representative: Kensett, John Hinton

(56) References cited:
- EP-A- 0 660 504
- EP-A- 0 696 870
- DE-A- 4 418 432
- US-A- 5 434 543

## Description

The present invention relates to a balanced oscillator having a band switching function suitable for use in a local oscillator such as a receiving tuner of a television signal.

A conventional balanced oscillator (hereinbelow, simply called an oscillation circuit) will be described with reference to Fig. 2. The emitters of a first oscillation transistor 41 and a second oscillation transistor 42 are connected to a constant current source 43 and a power source voltage is applied from a power source terminal B to the collectors via resistors 44, 44. Feedback circuits 45, 45 having the same structure are connected between the base of the first oscillation transistor 41 and the collector of'the second oscillation transistor 42 and between the base of the second oscillation transistor 42 and the collector of the first oscillation transistor 41, respectively. Each of the feedback circuits 45, 45 is constructed by a resistor 45a, a first capacitor 45b, and a second capacitor 45c which are connected in series.

A resonance circuit 46 is connected between connection points A and B each connecting the first capacitor 45b and the second capacitor 45c of each of the two feedback circuits 45, 45.

The resonance circuit 46 is a parallel resonance circuit having a varactor diode 47, two inductors 48 and 49, and the like.

Specifically, the varactor diode 47 is connected to a dc blocking capacitor 50 in series and is disposed between the connection points A' and B'. A correction capacitor 51 is connected to the varactor diode 47 in parallel. The anode of the varactor diode 47 is connected to the ground via a bias resistor 52 and a tuning voltage is supplied to the cathode from a tuning terminal Vt via a power supply resistor 53. As the resistance value of each of the bias resistor 52 and the power supply resistor 53, since a leakage current in the opposite direction of the varactor diode 47 is generally extremely small, a value is selected from a range from tens to hundreds KΩ.

The inductors 48 and 49 connected between the connection points A' and B' are connected to each other in series and a switching diode 55 is connected via a dc blocking capacitor 54 to the inductor 48 in parallel. One end of a bias resistor 56 is connected to the cathode of the switching diode 55 and a fixed bias voltage from a bias terminal Bf is applied to the cathode via the bias resistor 56. One end of a power supply resistor 57 is connected to the anode of the switching diode 55 and a switching voltage from a switching terminal Bs is supplied via the power supply resistor 57. In order to cut noises superimposed on the fixed bias voltage and the switching voltage, the other ends of the bias resistor 56 and the power supply resistor 57 are connected to the ground via dc blocking capacitors 58 and 59. The other end of the power supply resistor 57 is connected to the ground via a bias resistor 60 so that a current flows directly.

In the balanced oscillator having the above structure, for example, when a high-band signal of a high frequency among television signals is received (hereinbelow, called a "high-band state"), the switching diode 55 is made conductive and both ends of the inductor 48 are short-circuited in a high frequency manner, thereby increasing the resonance frequency of the resonance circuit 46. On the other hand, when a low-band signal of a low frequency among television signals is received (hereinbelow, called a "low-band state"), the switching diode 55 is made nonconductive and the switching diode 55 is disconnected from the inductor 48 in a high frequency manner, thereby lowering the resonance frequency of the resonance circuit 46. For this purpose, the fixed bias voltage from the bias terminal Bf is always applied to the cathode of the switching diode 55, and the switching voltage higher than the fixed bias voltage is supplied to the switching terminal Bs in the high band state. In the low band state, either the switching voltage of almost 0 volt is supplied to the switching terminal Bs, or the switching terminal Bs is released.

It is desirable from the viewpoint of electricity consumption that the fixed bias voltage applied to the bias terminal Bf and the switching voltage supplied to the switching terminal Bs are low. For example, the fixed bias voltage is set to 3 to 5 volts and the switching voltage in the high band state is set to 6 to 8 volts. The resistance value of each of the bias resistor 56 and the power supply resistor 57 is generally set to hundreds Ω in order to make the switching diode 55 sufficiently conductive..

In the conventional balanced oscillator as mentioned above, however, the switching diode 55 for band switching is connected in parallel to one (inductor 48) of the two inductors 48 and 49 which are connected in series. Consequently, in the low band state, the connection point A' is connected to the ground via the bias resistor 56 and the dc blocking capacitor 58 in series. In the high band state, the connection point A' is connected to the ground via the power supply resistor 57 and the dc blocking capacitor 59 in series.

Since the resistance values of the bias resistor 56 and the power supply resistor 57 are relatively small, highfrequency potentials at the connection points A' and B', namely, at both ends of the resonance circuit 46 with respect to the ground are not equal so that unbalance occurs.

The balanced oscillator has an advantage such that the level of a local oscillation signal transmitted to the peripheral circuits via space is low since there are two local oscillation signals whose phases are opposite with respect to the ground as a reference (phases are different by 180°). The balanced oscillator also has an advantage that even harmonics are not generated in the basic operation of the balanced oscillator. However, when an unbalanced state occurs in the resonance circuit 46 as mentioned above, a problem of losing the above advantages of the balanced oscillator occurs.

A further description of a variable-frequency oscillator circuit can be found in the German Patent Application DE 44 18 432 A1.

It is therefore an object of the invention to prevent a resonant circuit from becoming unbalanced at the time of band switching of a balanced oscillator.

In order to solve the above problems, a resonance circuit for a balanced oscillator of the invention comprises: a variable capacitance diode which is connected between a pair of resonance circuit connection terminals of the balanced oscillator and to which a control voltage for determining a capacitance value is supplied; a first inductor connected to the variable capacitance diode in parallel in a high frequency manner; second and third inductors whose inductance values are almost equal and which are connected to each other in series and are connected to the first inductor in parallel; and switching means which is connected between the second and third inductors and connects or disconnects the two inductors.

Preferably, the switching means is constructed by two serially connected switching diodes whose anodes or cathodes are connected to each other and is switched to an on-state or off state by a control voltage supplied between a middle point of the first inductor and the common connection point of the two switching diodes. Embodiments of the invention will now be described, by way of example only, with reference to the accompanying drawings, in which:
Fig. 1 is a circuit diagram of a balanced oscillator of the invention; and
Fig. 2 is a circuit diagram of a conventional balanced oscillator.

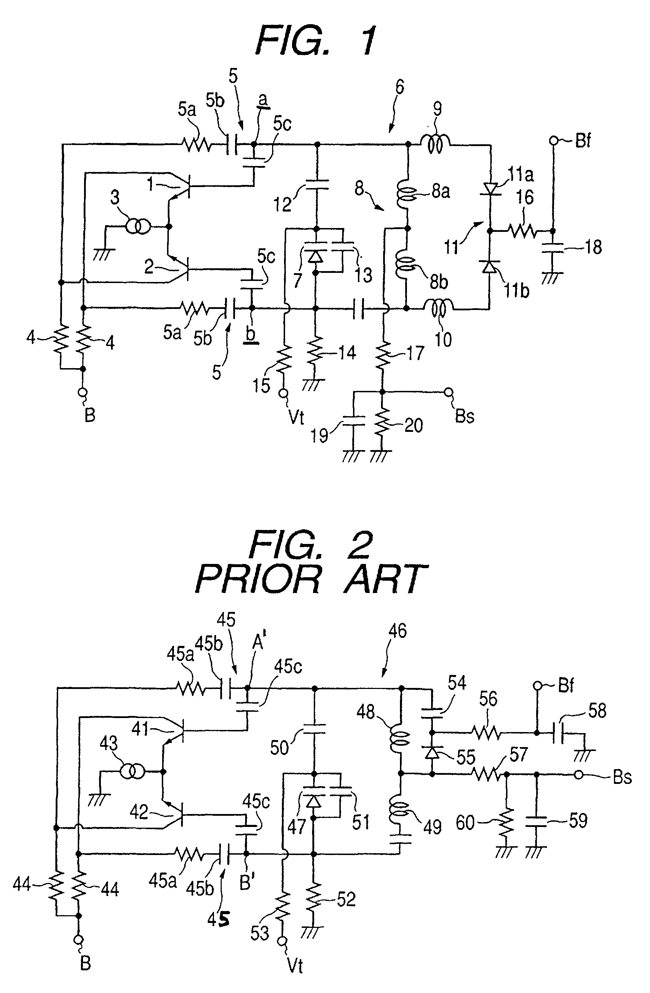

Fig. 1 is a circuit diagram of a balanced oscillator to which a resonance circuit for a balanced oscillator of the invention (hereinbelow, simply called a resonance circuit) is applied and the resonance circuit will be described with reference to Fig. 1.

The emitters of a first transistor 1 for oscillation and a second transistor 2 for oscillation are connected to a common constant current source 3 and a power source voltage is applied from a power source terminal B to the collectors via resistors 4, 4. Feedback circuits 5, 5 having the same structure are connected between the base of the first oscillation transistor 1 and the collector of the second oscillation transistor 2 and between the base of the second oscillation transistor 2 and the collector of the first oscillation transistor 1, respectively. Each of the feedback circuits 5, 5 is constructed by a resistor 5a, a first feedback capacitor 5b, and a second feedback capacitor 5c which are connected in series.

A resonance circuit 6 is connected between a first terminal a and a second terminal b each serving as a connection point of the first capacitor 5b and the second capacitor 5c of each of the two feedback circuits 5, 5.

The resonance circuit 6 is constructed as a parallel resonance circuit and comprises a varactor diode 7 disposed between the first and second terminals a and b, a first inductor 8 connected between the first and second terminals a and b, second and third inductors 9 and 10 whose inductance values are equal and which are similarly connected in series between the first and second terminals a and b, and first and second switching diodes 11a and 11b serving as switching means 11 connected between the second and third inductors 9 and 10.

Specifically, the varactor diode 7 is serially connected to a dc blocking capacitor 12 and is disposed between the first and second terminals a and b. A correction capacitor 13 is connected to the varactor diode 7 in parallel. The anode of the varactor diode 7 is connected to the ground via a bias resistor 14 and a tuning voltage is supplied from a tuning terminal Vt via a power supply resistor 15 to the cathode. As the resistance value of each of the bias resistor 14 and the power supply resistor 15, since a leakage current in the opposite direction of the varactor diode 7 is generally extremely small, a value is selected from a range from tens to hundreds KΩ.

The first inductor 8 connected between the first and second terminals a and b is constructed by fourth and fifth inductors 8a and 8b whose inductance values are equal.

On the other hand, the cathodes of the first and second switching diodes 11a and 11b serving as the switching means 11 disposed between the second and third inductors 9 and 10 are connected to each other and the anodes are connected to the second and third inductors 9 and 10, respectively.

One end of a bias resistor 16 is connected to the cathodes of the first and second switching diodes 11a and 11b and a fixed bias voltage from a bias terminal Bf is applied via the bias resistor 16 to the cathodes. One end of a power supply resistor 17 is connected to the connection point between the fourth and fifth inductors as a middle point of the first inductor 8 and a switching voltage from a switching terminal Bs is supplied via the power supply resistor 17. In order to cut noises occurring on the fixed bias voltage and the switching voltage, the other ends of the bias resistor 16 and the power supply resistor 17 are connected to the ground via dc blocking capacitors 18 and 19, respectively. The other end of the power supply resistor 17 is connected to the ground via a bias resistor 20 so that a current flows directly.

In the balanced oscillator having the above structure, for example, in case of receiving a high-band signal of a high frequency among television signals (hereinbelow, called a "high-band state"), the first and second switching diodes 11a and 11b are made conductive and the second and third inductors 9 and 10 are serially connected in a high frequency manner and are connected to the first inductor 8 in parallel.
Consequently, the inductance value as a whole is reduced and the resonance frequency of the resonance circuit 6 is increased. On the other hand, when a low-band signal of a low frequency among the television signals is received (hereinbelow, called a "low-band state"), the first and second switching diodes 11a and 11b are made nonconductive and the second and third inductors 9 and 10 are disconnected in a high frequency manner, thereby lowering the resonance frequency of the resonance circuit 6. For this purpose, the fixed bias voltage from the bias terminal Bf is always applied to the cathodes of the first and second switching diodes 11a and 11b and the switching voltage higher than the fixed bias voltage is supplied to the switching terminal Bs in the high band state. In the low band state, either the switching voltage of almost 0 volt is supplied to the switching terminal Bs or the switching terminal Bs is released.

As mentioned above, since the switching means 11 for band switching is disposed between the second and third inductors 9 and 10 in the balanced oscillator of the invention, even if the resistance value of the bias resistor 16 for applying the bias voltage to the switching means 11 is small, the balancing is not lost. This is because a virtual ground exists between the second and third inductors 9 and 10. Since the bias voltage is supplied to the connection point of the switching diodes by using the two switching diodes 11a and 11b as the switching means 11, the balanced oscillator having excellent balancing can be constructed.

In this case, by making the inductance values of the second and third inductors 9 and 10 almost equal, the balancing can be kept more.

The directions of the anodes and cathodes of the first and second switching diodes 11a and 11b can be made opposite. In this case, it is sufficient to change the supplying direction of the bias terminal voltage and the switching voltage and the high/low relation of the voltages. It is also possible to eliminate either the first switching diode 11a or the second switching diode 11b and directly connect the first inductor 9 and the cathode of the second switching diode 11b. Alternatively, the second inductor 10 can be directly connected to the cathode of the first switching diode 11a.

Further, the first inductor 8 can be constructed by a single inductor or two inductors of the fourth and fifth inductors 8a and 8b each having the inductance value of 1/2.

As described above, the balanced oscillator of the invention, which is defined in claim 1, comprises: the varactor diode which is connected between the first and second terminals and to which the tuning voltage for changing the oscillation frequency is supplied; the first inductor connected between the first and second terminals; second and third inductors serially connected between the first and second terminals; and the switching means which is arranged between the second and third inductors and connects or disconnects the second and third inductors in a high frequency manner. Since the switching means is provided at a virtual ground point existing between the second and third inductors, the balanced oscillator whose balancing is excellent can be constructed.

According to the balanced oscillator of the invention, since the inductance values of the second and third inductors are set to be almost equal, the balancing is improved more.

According to the balanced oscillator of the invention, the switching means is constructed by a switching diode and the voltage to make the switching diode to be conductive or nonconductive is supplied between the middle point of the first inductor and one end of the switching diode. Consequently, the second and third inductors can be easily connected in series and can be also connected to the first inductor in parallel.

According to the balanced oscillator of the invention, the switching means is constructed by the switching diode, the first inductor is constructed by the fourth and fifth inductors which are connected in series, and the switching voltage for making the switching diode to be conductive or nonconductive is supplied between the connection point of. the fourth and fifth inductors and one end of the switching diode. Consequently, the second and third inductors can be connected in series and can be easily connected to the fourth and fifth inductors in parallel.

According to the balanced oscillator of the invention, the switching diode is constructed by the first and second switching diodes whose anodes or cathodes are connected to each other, and the voltage for switching is applied between the middle point of the first inductor or the connection point of the fourth and fifth inductors and the anodes, or between the middle point of the first inductor or the connection point of the fourth and fifth inductors and the cathodes, so that the balancing of the local oscillator is further improved.

## Claims

1. A resonance circuit for a balanced oscillator, comprising:
a variable capacitance diode (7) which is connected between a pair of resonance circuit connection terminals (a, b) of a balanced oscillator and to which a control voltage (Vₜ) for determining a capacitance value is supplied;
a first inductor (8) connected to said variable capacitance diode (7) in parallel in a high frequency manner;
second and third inductors (9, 10) whose inductance values are almost equal and which are connected to each other in series and connected to said first inductor (8) in parallel; and
switching means (11) which is connected between said second and third inductors (9, 10) and connects or disconnects the two inductors.

2. A resonance circuit for a balanced oscillator according to claim 1, wherein said switching means (11) is constructed by two serially connected switching diodes (11a, 11b) whose anodes or cathodes are connected to each other and is switched to an on-state or to an off-state by a further control voltage supplied between the middle point of said first inductor (8) and the common connection point of the two switching diodes (11a, 11b).

## Patentansprüche

1. Resonanzschaltung für einen ausgeglichenen Oszillator mit:
einer Diode mit variabler Kapazität (7), die zwischen einem Paar von Resonanzschaltungs-Verbindungsanschlüssen (a, b) eines ausgeglichenen Oszillators geschaltet ist, und an die eine Steuerspannung (Vₜ) zum Bestimmen eines Kapazitätswerts geliefert wird;
einem ersten Induktor (8), der mit der Diode mit variabler Kapazität (7) auf eine Hochfrequenz-Art parallel geschaltet ist;
zweite und dritte Induktoren (9, 10), deren Induktivitätswerte fast gleich sind und die miteinander in Reihe und mit dem ersten Induktor (8) parallel geschaltet sind; und
einem Schaltmittel (11), das zwischen den zweiten und dritten Induktoren (9, 10) geschaltet ist und die beiden Induktoren verbindet oder trennt.

2. Resonanzschaltung für einen ausgeglichenen Oszillator gemäß Anspruch 1, bei der das Schaltmittel (11) durch zwei seriell geschaltete Schaltdioden (11a, 11b) aufgebaut ist, deren Anoden oder Kathoden miteinander verbunden sind, und das in einen An- oder in einen AusZustand durch eine weitere, zwischen dem Mittelpunkt des ersten Induktors (8) und dem gemeinsamen Verbindungspunkt der beiden Schaltdioden (11a, 11b) gelieferten Steuerspannung geschaltet wird.

## Revendications

1. Un circuit résonateur pour oscillateur équilibré comprenant:
une diode à capacité variable (7) située entre et reliant une paire de bornes (a,b) de connection de circuit résonateur d'un oscillateur équilibré et qui reçoit une tension de contrôle (Vₜ) pour déterminer une valeur de capacité:
une première bobine d'inductance (8) connectée à cette diode à capacité variable (7) en montage parallèle à haute fréquence;
une deuxième et une troisième bobine d'induction (9,10), ayant des valeurs d'induction presque égales et qui sont connectées l'une à l'autre sériellement et à la première bobine d'induction (8) en parallèle; et
un interrupteur (11) connecté avec les deuxième et la troisième bobines d'induction (9,10) et qui connecte ou déconnecte les deux bobines d'induction.

2. Un montage de résonance pour un oscillateur équilibré selon la revendication 1, dans lequel l'interrupteur (11) est formé par deux diodes (11a 11b) servant d'interrupteurs, dont les anodes ou les cathodes sont reliées l'une à l'autre et qui est mis en marche ou coupé par une autre tension de contrôle prévue au point intermédiaire entre la première bobine d'induction (8) et le point de connection commun des deux diodes servant d'interrupteurs (11a, 11b).
